# EUROPÄISCHE PATENTSCHRIFT

(11) **EP 2 156 479 B1**
(45) Veröffentlichungstag und Bekanntmachung des Hinweises auf die Patenterteilung: **28.08.2013**
(21) Anmeldenummer: 08750213.4
(22) Anmeldetag: 08.05.2008
(51) Int. Cl.: H01L 41/083, H01L 41/047, H01L 41/273

(54) **PIEZOELEKTRISCHES VIELSCHICHTBAUELEMENT**
PIEZOELECTRIC MULTILAYER COMPONENT
COMPOSANT MULTICOUCHE PIÉZOÉLECTRIQUE

(30) Priorität: 11.05.2007 DE 102007022091; 08.08.2007 DE 102007037500
(43) Veröffentlichungstag der Anmeldung: 24.02.2010
(73) Patentinhaber: Epcos AG, 81669 München (DE)
(72) Erfinder: DÖLLGAST, Bernhard, 8530 Deutschlandsberg (AT); SCHMIDT, Johann, 8010 Graz (AT)
(74) Vertreter: Epping - Hermann - Fischer
(86) Internationale Anmeldenummer: PCT/EP2008/055720
(87) Internationale Veröffentlichungsnummer: WO 2008/138872

(56) Entgegenhaltungen:
- WO-A-2006/087871
- WO-A-2007/048756
- DE-A1- 10 307 825

## Beschreibung

Es wird ein piezoelektrisches Vielschichtbauelement mit einer Schicht beschrieben, welche unter bestimmten mechanischen Belastungen einreißt und somit dem Aufbau von Spannungen im Vielschichtbauelement entgegenwirkt.

In WO 2006/087871 A1 ist ein piezoelektrisches Vielschichtbauelement beschrieben, welches Elektrodenschichten aufweist, die einen Riss zwischen den Elektrodenschichten und benachbarten keramischen Schichten induzieren.

In EP 1850403 und WO 2007/048756 sind weitere Beispiele offenbart.

Eine zu lösende Aufgabe besteht darin, ein piezoelektrisches Vielschichtbauelement anzugeben, welches unter mechanischer Belastung über einen längeren Zeitraum funktionstüchtig bleibt.

Es wird ein piezoelektrisches Vielschichtbauelement mit einem Grundkörper angegeben, der einen Stapel von dielektrischen Schichten, Elektrodenschichten und zumindest einer mechanisch instabilen Schicht aufweist. Die mechanisch instabile Schicht ist zumindest größtenteils in einer inaktiven Zone bzw. in einem inaktiven Bereich angeordnet, der sich in einem Bereich des Vielschichtbauelements befindet, in dem sich benachbarte Elektrodenschichten in orthogonaler Projektion nicht überlappen bzw. ein elektrisches Feld nicht oder zumindest nur geringfügig zur Auslenkung des Stapels in diesem Bereich führt. Die mechanisch instabile Schicht kann als Sollbruchschicht bezeichnet werden.

Als Sollbruchschicht wird sowohl die ein Sollbruchmaterial enthaltende Schicht vor der Fertigstellung des Vielschichtbauelements als auch die Sollbruchschicht bei bzw. nach der Fertigstellung des Vielschichtbauelements verstanden.

Die Sollbruchschicht reißt unter bestimmten mechanischen Belastungen beim Betrieb oder bei der Polung des Bauelementes ein und baut somit mechanische Spannungen im Vielschichtbauelement, besonders in der inaktiven Zone, ab.

Vorteilhafterweise bilden sich durch die Sollbruchschicht Risse lediglich in der inaktiven Zone des Vielschichtbauelements. Die maximale Propagation der Risse wird durch Abmessungen der Sollbruchschichten bestimmt. Daher können sich Risse auch nicht quer durch das Vielschichtbauelement fortsetzen. Es wird somit ein Vielschichtbauelement mit hoher Langzeitstabilität geschaffen, wobei die Langzeitstabilität vorteilhafterweise nicht zur Folge hat, dass beispielsweise der Auslenkungsweg des Vielschichtbauelements verringert wird. Letzteres könnte stattdessen eintreten, wenn Risse quer durch den Stapel verlaufen, da diese dann auch durch die auslenkende, aktive Zone des Vielschichtbauelements verlaufen würden.

Die inaktive Zone des Vielschichtbauelements ist unter normalen Umständen keinen starken elektromagnetischen bzw. elektrischen Feldern ausgesetzt, sodass ein piezoelektrischer Auslenkungseffekt nicht oder zumindest nur in geringem Maße zustande kommt. Somit bilden sich jedoch mechanische Spannungen zwischen der sich auslenkenden aktiven Zone und der sich nicht ausdehnenden inaktiven Zone. Da die Sollbruchschichten durch ihre Fähigkeit, kontrolliert einzureißen, einen Abbau dieser Spannungen ermöglichen, wird ein Klemmeffekt in der inaktiven Zone vermieden. Dies trägt ebenfalls zur Langzeitstabilität des Vielschichtbauelements bei.

Gemäß einer Ausführungsform des Vielschichtbauelements weist es Außenkontakte auf. Diese können als elektrisch leitende Schichten auf eine Seitenfläche des Stapels aufgebracht werden und mit bis an eine entsprechende Seitenfläche des Stapels herausgeführten Elektrodenschichten kontaktiert sein.

Ist die inaktive Zone aufgrund der Ausdehnung der mit ihr verbundenen aktiven Zone des Vielschichtbauelements bestrebt, sich auseinander ziehen zu lassen, würde ein bestehender elektrischer Kontakt einer Elektrodenschicht mit einem Außenkontakt von Unterbrechung bedroht sein. Anders ausgedrückt klemmt die inaktive Zone die aktive Zone bezogen auf ihre Längsausdehnung ein bzw. die aktive Zone erfährt eine Klemmung durch die nicht oder nur geringfügig auslenkende inaktive Zone. Hierdurch entstehen mechanische Spannungen, welche unkontrolliert zur Zerstörung oder Beschädigung zumindest eines Teils des Vielschichtbauelement führen könnten.

Die mechanisch instabilen Schichten ermöglichen jedoch eine zuverlässige Kontaktierung der Elektrodenschichten mit Außenkontakten. Jede Sollbruchschicht der inaktiven Zone erlaubt den gezielten Abbau von mechanischer Spannung zwischen der Elektrodenschicht und dem Außenkontakt, indem ein Riss neben einer Elektrodenschicht verläuft. Dadurch kann zumindest ein Teil der mechanischen Spannung auf die Kontaktstelle zwischen dem Außenkontakt und der Elektrodenschicht durch den Riss aufgenommen bzw. kompensiert werden.

Die Beschaffenheit der Sollbruchschicht ist derart gewählt, dass sie ein Einreißen der Sollbruchschicht bei Zugspannungen, die auf sie einwirken, ermöglicht. Beispielsweise kann die Sollbruchschicht Löcher, Einbuchtungen und / oder eine inhomogene Festkörperverteilung, wie beispielsweise eine Kristallstruktur mit einer Unterbrechung oder mehreren Unterbrechungen, aufweisen. Die Sollbruchschicht kann ein keramisches Material, insbesondere ein organisches Material und / oder ein Metall enthalten.

Gemäß der Erfindung wie beansprucht weist die Sollbruchschicht ein während der Herstellung des Stapels durch die dielektrischen Schichten diffundierbares Material auf. Vorteilhafterweise wird das Materialgefüge der Sollbruchschicht aufgrund des ausdiffundierten Materials derart geschwächt, dass die Sollbruchschicht bei Zugbelastungen einreißen kann. Dabei enthält die Sollbruchschicht eine Materialzusammensetzung umfassend ein leicht aus der Sollbruchschicht diffundierbares und ein aus der Sollbruchschicht schlecht diffundierbares Material.

Eine Diffusion von Material aus der Sollbruchschicht kann mittels eines Prozesses initiiert werden, der den Ausgleich bzw. das Aufheben eines Konzentrationsgradienten dieses Materials in einem Raum innerhalb des Vielschichtbauelements ermöglicht. Eine höhere Konzentration eines Materials in der Sollbruchschicht im Vergleich zu anderen Bereichen des Vielschichtbauelements birgt die höhere Wahrscheinlichkeit, dass das Material der Sollbruchschicht in die Richtung geringerer Konzentration wandert. Auch können Unterschiede in den Diffusionskoeffizienten des in der Sollbruchschicht enthaltenen Materials im Vergleich zu einem anderen Bereich bzw. anderen Bereichen des Vielschichtbauelements berücksichtigt werden, um der Sollbruchschicht ihre benötigte Sollbrucheigenschaft zu verleihen. Da der Diffusionskoeffizient von Temperatur und / oder Druck abhängig ist, können diese Einflüsse bei Auswahl des Materials der Sollbruchschicht berücksichtigt werden.

Sollte beispielsweise die Sollbruchschicht 10¹⁰ diffundierbare Teilchen eines ersten Typs enthalten, d.h. Teilchen, die frei beweglich sind und auch nicht in einer Kristallstruktur festgehalten werden, und ein anderer Bereich des Vielschichtbauelements eine geringere bzw. gar keine Konzentration dieser Teilchen in einem Bereich aufweisen, beispielsweise also 10⁸ Teilchen, so ist die Wahrscheinlichkeit um einen Faktor 100 größer, dass Teilchen der mechanischen instabilen Schicht zufällig in die Richtung geringerer bzw. mangelnder Konzentration wandern.

Beispielsweise könnte die Diffusion während einer Erwärmung, beispielsweise vor oder während des Sinterns, des Stapels stattfinden bzw. durch sie unterstützt werden. Insbesondere kann der Prozess der Diffusion mittels Wärmezufuhr beschleunigt werden. Bei einer geeigneten Wärmezufuhr können sich die Teilchen der Sollbruchschicht von Bindungen untereinander oder mit anderen Materialien der Sollbruchschicht trennen, um somit durch das Vielschichtbauelement diffundieren zu können.

Eine Wärmezufuhr ist als externe Energiezufuhr zu betrachten, sodass eine durch die Diffusion ausgedrückte Zunahme an Entropie im Vielschichtbauelement, indem sich beispielsweise Materialkonzentrationsgradienten aufheben, nicht unbedingt stattfinden muss. Mittels der Wärmezufuhr kann ein thermischer Gradient bzw. können thermische Gradienten erzeugt werden, die lose bzw. ausdiffundierbare Teilchen aus den Sollbruchschichten in Bereiche des Vielschichtbauelements mit niedrigerer Temperatur zwingen. Die Diffusion kann dabei als aktive Diffusion bezeichnet werden.

Gemäß einer Ausführungsform des Vielschichtbauelements enthalten speziell die dielektrischen Schichten des Stapels Material bzw. Materialien in anderen Konzentrationen, als sie in der Sollbruchschicht vorhanden sind. Somit ergibt sich zwischen der Sollbruchschicht und den dielektrischen Schichten ein Konzentrationsgradient. Dabei kann das von einer Sollbruchschicht abgewanderte Material durch eine oder mehrere dielektrischen Schichten des Vielschichtbauelements diffundieren.

Wenn die dielektrischen Schichten makroskopisch als poröse Wände betrachtet werden, mittels derer die Elektrodenschichten voneinander beabstandet sind, kann die Diffusion durch diese "Wand" als eine durch einen Konzentrations- oder Aktivitätsgradient verursachte Diffusion betrachtet werden, welcher eine konzentrationsausgleichende Wirkung hat. Das ausdiffundierbare Material der Sollbruchschicht kann also mittels eines osmotischen Effekts in einen anderen Bereich des Vielschichtbauelements diffundieren.

Gemäß eines Beispiels des Vielschichtbauelements ist ein die Sollbruchschicht bildendes bzw. mitbildendes Material elektrisch leitend und dabei zu einem höheren Anteil in den Elektrodenschichten enthalten. Das Material könnte beispielsweise Silber sein. Beispielsweise könnten die Elektrodenschichten Silber zu einem Anteil von 75% und Palladium zu einem Anteil von 25% aufweisen. Die Sollbruchschicht könnte dabei einen Anteil von Silber > 75% aufweisen, wobei die Sollbruchschicht darüber hinaus auch andere Materialien als Palladium, das in den Elektrodenschichten enthalten ist, enthalten könnte. Vorzugsweise wird darauf geachtet, den Anteil an verhältnismäßig teuren Edelmetallen in den Sollbruchschichten gering gehalten wird.

Die Sollbruchschicht ist gemäß einer Ausführungsform porös. Enthält sie ein Metall, so ist der Anteil bzw. das Materialgefüge des Metalls derart zu gestalten, dass die Sollbruchschicht keinen oder zumindest lediglich einen geringfügigen Effekt auf die Verteilung von elektromagnetischen Feldern im Vielschichtbauelement hat. Es wird bevorzugt, dass die Sollbruchschicht nicht als Elektrode fungiert bzw. keine Elektrodenfunktion aufweist. Dabei ist die Sollbruchschicht gemäß einer Ausführungsform des Vielschichtbauelements nicht mit Außenkontakten elektrisch kontaktiert.

Gemäß einer bevorzugten Ausführungsform des Vielschichtbauelements ist einer jeden Elektrodenschicht zumindest eine Sollbruchschicht in Stapelrichtung benachbart. Außerdem können sich auf einer Ebene des Stapels mehrere Sollbruchschichten lateral gegenüberliegen, sodass das Vielschichtbauelement von mehreren Seitenflächen her einreißen kann um damit mechanischen Spannungen effektiv abzubauen.

In einer weiteren Ausführungsform des Vielschichtbauelements weisen die dielektrischen Schichten, welche mit aufgedrucktem, eine Elektrodenschicht bildenden Elektrodenmaterial versehen sind, auf ihrer Oberseite neben der Elektrodenschicht einen Randbereich auf, der sich vorzugsweise in der inaktiven Zone befindet. Im Vergleich zu einer benachbarten Elektrodenschicht weist der Randbereich einen höheren Anteil an leicht diffundierbarem Material auf, wie beispielsweise Silber, und umfasst eine Sollbruchschicht.

Die Sollbruchschicht ist vorzugsweise neben der Elektrodenschicht in derselben Ebene angeordnet und ist von dieser mittels eines Dielektrikums, beispielsweise mittels eines Luftspalts oder mittels eines keramischen Materials, elektrisch isoliert. Zusätzlich zu den dielektrischen Schichten, die neben der Elektrodenschicht mit einer Sollbruchschicht versehen sind, kann das Vielschichtbauelement auch dielektrische Schichten in einer benachbarten Ebene aufweisen, die nur eine Sollbruchschicht aufweisen, die größtenteils in einem inaktiven Bereich angeordnet ist.

Die neben einer Elektrodenschicht in derselben Ebene angeordnete Sollbruchschicht vermindert mit den weiteren Sollbruchschichten in anderen Ebenen des Vielschichtbauelements die mechanischen Spannungen innerhalb der inaktiven Zone und erhöht dadurch die Zuverlässigkeit des Vielschichtbauelements.

Die zusätzliche Sollbruchschicht neben der Elektrodenschicht hat den Vorteil, dass bei der Laminierung die einzelnen Schichten des Vielschichtbauelements keine Dickenunterschiede in Stapelrichtung durch eigene plastische Deformation kompensieren müssen. Eine plastische Deformation könnte dann zustande kommen, wenn eine dielektrische bzw. piezokeramische Schicht, welche auf einer Elektrodenschicht aufliegt, auf die tiefer liegende Oberseite einer unterhalb liegenden und benachbarten dielektrischen Schicht heruntergebogen werden würde. Jede so gebogene dielektrische Schicht steht somit unter mechanischer Spannung, welche Risse verursachen könnte. Multipliziert sich dieser Effekt über mehrere Schichten des Vielschichtbauelements, so könnte dies zu unterschiedlichen Höhenabmessungen des Vielschichtbauelements führen und mechanische Spannungen über die gesamte Höhe des Vielschichtbauelements hervorrufen. Wenn jedoch neben der Elektrodenschicht im Randbereich der dielektrischen Schicht zusätzlich eine Sollbruchschicht angeordnet ist, wird das Vielschichtbauelement im Wesentlichen eine einheitliche Höhe bekommen, sodass mechanische Spannungen vermieden werden können.

Außerdem wird ein Verfahren zur Herstellung eines piezoelektrischen Vielschichtbauelements angegeben, bei dem erste piezokeramische Folien mit einem Sollbruchmaterial bedruckt werden, dessen Gefüge im Laufe der Herstellung des Vielschichtbauelements mechanisch instabil wird und dabei eine Sollbruchschicht hinterlässt. Es werden die ersten piezokeramischen Folien und zweite piezokeramischen Folien, welche Elektrodenschichten aufweisen, derart zu einem Stapel bereitgestellt bzw. zusammengefügt, dass die Fläche einer Sollbruchschicht in orthogonaler Projektion keine Überlappfläche mit einer benachbarten Elektrodenschicht aufweist. Somit sollen sich die Sollbruchschichten stets in einer inaktiven Zone des Vielschichtbauelements befinden.

Gemäß einer Ausführungsform des Herstellungsverfahrens wird eine dritte bzw. weitere piezokeramische Folie sowohl mit Elektrodenmaterial als auch mit Sollbruchmaterial derart bedruckt, dass die dritte piezokeramische Folie sowohl mit einer Elektrodenschicht als auch mit einer Sollbruchschicht versehen ist, wobei die Schichten in derselben Ebene nebeneinander angeordnet sind.

Der Stapel kann anschließend zu einem monolithischen Vielschichtbauelement gesintert werden. Dabei können erste, zweite und dritte piezokeramische Folien abwechselnd und in beliebiger Reihenfolge miteinander verstapelt werden. Vor dem Sintern könnte der Stapel in einem Trocknungsprozess entbindert werden.

Gemäß einer Ausführungsform des Verfahrens wird die mechanische Instabilität einer Sollbruchschicht während des Erwärmens des Vielschichtbauelements erreicht. Dabei könnte es sich um einen zu diesem Zweck speziell geeigneten, separaten Erwärmungsvorgang handeln. Alternativ könnte die mechanische Instabilität der Sollbruchschicht während des Sinterns des Vielschichtbauelements erreicht werden.

Gemäß einer Ausführungsform des Herstellungsverfahrens werden die ersten und die zweiten piezokeramischen Folien einzeln abwechselnd übereinander gestapelt. Somit weist jede zweite piezokeramische Schicht des Vielschichtbauelements eine Sollbruchschicht auf. Alternativ könnte jedoch mittels eines anderen Prozesses eine Mehrzahl von zweiten piezokeramischen Folien zu einem Teilstapel bereitgestellt werden und danach eine erste piezokeramische Folie mit aufgedrucktem Sollbruchmaterial auf den Teilstapel gelegt werden. Der Prozess kann wiederholt werden, bis ein aus Teilstapeln gebildeter Stapel zustande kommt.

Gemäß einer Ausführungsform hinterlässt das Sollbruchmaterial im Laufe des Herstellungsverfahrens eine poröse Sollbruchschicht auf den ersten piezokeramischen Schichten. Das kann auf verschiedene Art und Weise erreicht werden. Beispielsweise könnte das Material bzw. die Materialzusammensetzung teilweise aus der Sollbruchschicht diffundieren. Die Materialzusammensetzung könnte jedoch auch derart beschaffen sein, dass sich bei einer bestimmten Temperatur ein Teil der Zusammensetzung verflüchtigt und danach Löcher bzw. Poren hinterlässt. Dabei könnte es sich um organisches Material handeln. Es wird bevorzugt, dass eine niedrigere Konzentration des Sollbruchmaterials in einem von einer Sollbruchschicht freien Bereich des Vielschichtbauelements vorhanden ist, sodass eine Diffusion des Sollbruchmaterials von der Sollbruchschicht in einen die niedrigere Konzentration des Sollbruchmaterials aufweisenden Bereichs des Vielschichtbauelements stattfinden kann.

Die beschriebenen Gegenstände werden anhand der folgenden Ausführungsbeispiele und Figuren näher erläutert. Dabei zeigt bzw. zeigen:
- Figur 1: ein Vielschichtbauelement mit einem Stapel von dielektrischen Schichten, Elektrodenschichten sowie Sollbruchschichten,
- Figur 2: eine Explosionsdarstellung eines Teils des mit der Figur 1 gezeigten Vielschichtbauelements,
- Figur 3: den Zustand eines Teils des mit der Figur 1 gezeigten Vielschichtbauelements wenn eine Sollbruchschicht einreißt,
- Figur 4: eine weitere Ausführungsform des Vielschichtbauelements bei dem die Sollbruchschichten in der Ebene der Elektrodenschicht liegen,
- Figur 5: zeigt eine Aufsichtdarstellung der Ausführungsform gemäß Figur 4.

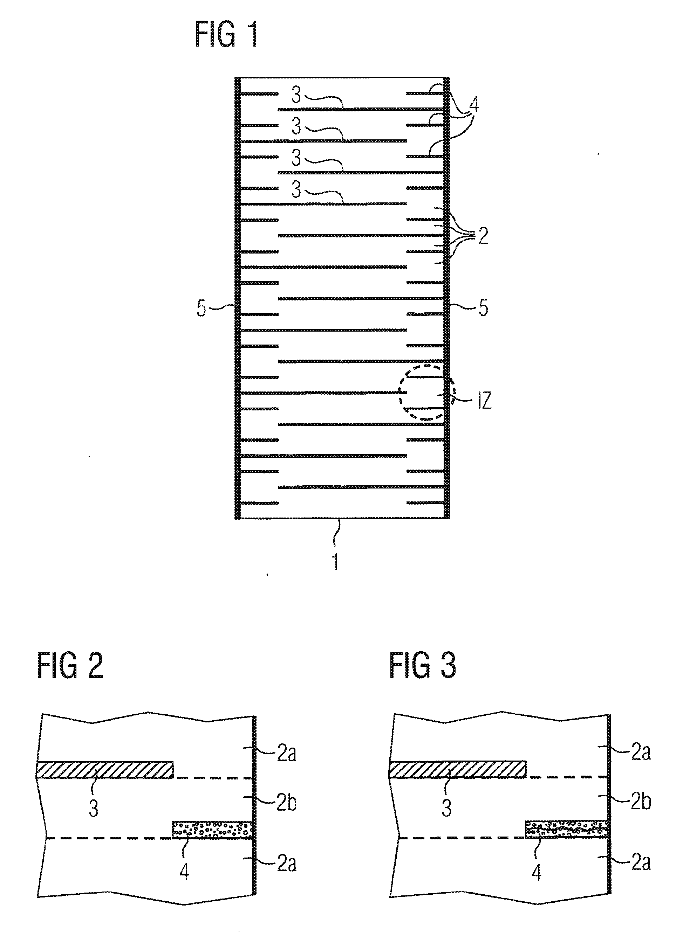

Figur 1 zeigt ein piezoelektrisches Vielschichtbauelement mit einem monolithisch aufgebauten Grundkörper 1, der einen Stapel von piezokeramischen Schichten 2 und Elektrodenschichten 3 aufweist. Jede zweite dielektrische Schicht ist im Randbereich mit einer Sollbruchschicht 4 bedruckt. Die anderen dielektrischen Schichten 2 sind dagegen bis in den inneren Bereich mit Elektrodenstrukturen bzw. Schichten 3 bedruckt. Die Sollbruchschichten 4 sind in der inaktiven Zone IZ des Stapels angeordnet, wo keine zwei in Stapelrichtung benachbarte Elektrodenschichten 3 sich in orthogonaler Projektion überlappen. Die Elektrodenschichten 3 und die Sollbruchschichten enthalten beide elektrisch leitende Materialien, jedoch zu unterschiedlichen Anteilen. Beispielsweise enthalten die Elektrodenschichten 3 zu 20% Silber und zu 80% Palladium. Dagegen enthalten die Sollbruchschichten 4 mehr als 20% Silber, beispielsweise 70% Silber, und nur 30% Palladium. Anhand des dadurch entstehenden Konzentrationsgradienten von Silber kann das bewegliche Silber von der Sollbruchschicht zur einer benachbarten Elektrodenschicht 3 gelangen bzw. diffundieren. Dieser Effekt kann bereits vor einem Sintervorgang beginnen. Dabei wird eine Sollbruchschicht hinterlassen, die keine als Elektrode taugliche durchgehende Struktur aufweist und mechanisch instabil ist. Insbesondere wird eine poröse Sollbruchschicht hinterlassen.

Figur 2 zeigt eine Explosionsdarstellung eines Bereichs des mit der Figur 1 gezeigten Vielschichtbauelements. Es werden in Stapelrichtung benachbarte piezokeramische Schichten 2 gezeigt, wobei eine erste piezokeramische Schicht 2a mit einer Sollbruchschicht 4 versehen ist, dessen Material bereits teilweise ausdiffundiert ist und somit Poren bzw. Einbuchtungen oder Aussparungen hinterlassen hat. Auf dieser ersten piezokeramischen Schicht 2a ist eine zweite piezokeramische Schicht 2b angeordnet, welche mit einer aufgedruckten Elektrodenschicht 3 versehen ist. Diese Elektrodenschicht ist an einem Ende mit einem Außenkontakt 5 des Vielschichtbauelements kontaktiert.

Figur 3 zeigt den mit der Figur 2 gezeigten Bereich des piezoelektrischen Vielschichtbauelements, diesmal jedoch mit einem dunkel eingezeichneten Schlitz, der einen unter einer bestimmten Zugbelastung entstandenen Riss darstellt. Der Riss verläuft dabei maximal bis an das dem Innern des Vielschichtbauelements zugewandte Ende der Sollbruchschicht 4. Der Riss verläuft durch die Sollbruchschicht 4; dabei jedoch weder an der Grenzfläche zwischen der piezokeramischen Schicht 2a bzw. 2b und der Sollbruchschicht 4 noch durch die piezokeramischen Schichten selbst.

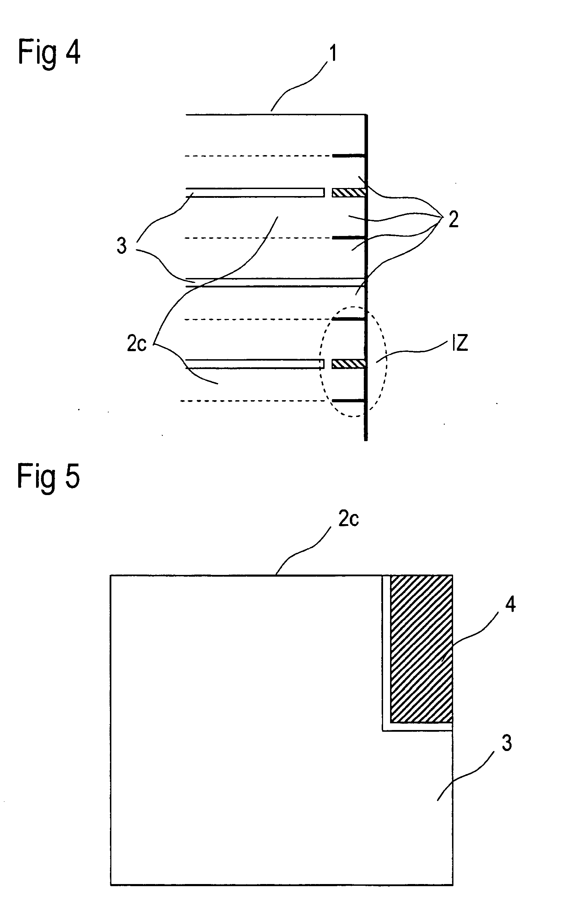

Figur 4 zeigt eine weitere Ausführungsform des piezoelektrischen Vielschichtbauelements mit einem monolithisch aufgebauten Grundkörper 1, der einen Stapel von piezokeramischen Schichten 2 und Elektrodenschichten 3 aufweist. Jede zweite dielektrische Schicht 2a ist in einer Ecke ihres Randbereichs mit einer Sollbruchschicht 4 bedruckt. Die dazwischen liegenden dielektrischen Schichten 2b sind bis auf einen Randbereich mit Elektrodenstrukturen bzw. Schichten 3 bedruckt. Eine dielektrische Schicht 2c, die mit einer Elektrodenschicht 3 versehen ist, weist vorzugsweise im Randbereich, der im Bereich der inaktiven Zone IZ liegt, eine Sollbruchmaterial enthaltende Sollbruchschicht 4 auf. Die Sollbruchschichten 4 sind in der inaktiven Zone IZ des Stapels angeordnet. Die Sollbruchschichten 4 enthalten einen höheren Anteil an leicht diffundierbaren Materialien, wie beispielsweise einen höheren Silberanteil, als eine benachbarte Elektrodenschicht 3. Die Randbereiche der dielektrischen Schichten 2c, die mit einer Sollbruchschicht 4 versehen sind, werden elektrisch von der Elektrodenschicht 3 isoliert, so dass es zu keinem Kurzschluss zwischen der Elektrodenschicht 3 und der Sollbruchschicht 4 kommen kann.

Figur 5 zeigt die Aufsicht auf eine dielektrische Schicht 2c mit einer Elektrodenschicht 3 und einer in einem Randbereich aufgedruckten Sollbruchschicht 4. Die Sollbruchschicht 4 ist elektrisch von der Elektrodenschicht 3 isoliert. Die Sollbruchschicht 4 weist vorzugsweise die Form eines Rechtecks auf. Der Rand der Elektrodenschicht 3 verläuft, mit einem Abstand eines schmalen isolierenden Spalts, zumindest auf zwei Seiten im Wesentlichen parallel zum Rand der Sollbruchschicht 4, so dass die Elektrodenschicht 3 beispielsweise die Form eines "L" aufweisen könnte. Einander zugewandte Ränder der Elektrodenschicht 3 bzw. der Sollbruchschicht zeichnen somit komplementäre Verläufe zueinander auf.

Das Vielschichtbauelement wird vorzugsweise folgendermaßen hergestellt:

Es werden erste und zweite piezokeramische Grünfolien bereitgestellt, deren Zusammensetzungen gleich sein können. Sie enthalten jeweils vorzugsweise eine PZT Keramik. Zur besseren Handhabbarkeit der Grünfolien können sie jeweils einen organischen Binder enthalten. Erste piezokeramische Grünfolien werden mit einem Sollbruchmaterial und zweite piezokeramische Grünfolien mit einem Elektrodenmaterial bedruckt. Bedrucktes Sollbruchmaterial und bedrucktes Elektrodenmaterial bilden jeweils eine Sollbruchschicht und eine Elektrodenschicht auf den jeweiligen piezokeramischen Grünfolien. Die Grünfolien werden derart bedruckt bzw. zurechtgeschnitten, dass das Sollbruchmaterial lediglich im Randbereich einer ersten piezokeramischen Grünfolie angeordnet ist und das sich Elektrodenmaterial vom Rand einer zweiten piezokeramischen Grünfolie bis in den zentralen Bereich der Grünfolie erstreckt. Das Sollbruchmaterial besteht aus 90% Silber und 10% Palladium. Das Elektrodenmaterial besteht aus 75% Palladium und 25% Silber. Alternativ könnte das Sollbruchmaterial aus 98% Silber und 2% Palladium und das Elektrodenmaterial aus 90% Silber und 10% Palladium bestehen.

Es werden erste und zweite Grünfolien anschließend abwechselnd übereinander gestapelt um einen grünen Stapel zu bilden, der einen piezoelektrisch aktiven Bereich und einen piezoelektrisch inaktiven Bereich aufweist. Der Stapel wird anschließend entbindert und gesintert. Spätestens beim Sintervorgang diffundiert das Silber von der Sollbruchschicht zu einer Elektrodenschicht. In bzw. an der Elektrodenschicht wird dabei Silber angereichert; dieses hat jedoch keine negative Auswirkung auf die Funktionalität der Elektrodenschicht. Das Palladium bleibt dagegen in beiden Schichten vorhanden bzw. diffundiert weniger aus, da es einen um 1 bis 2 Größenordnungen geringeren Diffusionskoeffizienten aufweist, als Silber.

Nach dem Sintervorgang können Außenkontakte als Schichten auf Seitenflächen des Vielschichtbauelements aufgebracht werden und die Elektrodenschichten dadurch kontaktiert werden. Gegebenenfalls können dabei die jeweiligen Seitenflächen des gesinterten Stapels geschliffen werden, um die Elektrodenschichten zur vereinfachten Kontaktierung mit den Außenkontakten zu exponieren.

### Bezugszeichenliste

- 1: Grundkörper
- 2: dielektrische Schichten
- 2a: dielektrische Schicht mit aufgedrucktem Sollbruchmaterial
- 2b: dielektrische Schicht mit aufgedrucktem Elektrodenmaterial
- 3: Elektrodenschichten
- 4: mechanisch instabile Schichten
- 5: Außenkontakte

- IZ: inaktive Zone

## Patentansprüche

1. Piezoelektrisches Vielschichtbauelement, umfassend einen Grundkörper (1), der einen Stapel von dielektrischen Schichten (2, 2a, 2b), Elektrodenschichten (3) und zumindest eine Sollbruchschicht (4) aufweist, wobei
- die Sollbruchschicht zumindest größtenteils in einer inaktiven Zone (5) angeordnet ist, und wobei
- die Sollbruchschicht unter bestimmten Zugbelastungen einreißt, und wobei
- die Sollbruchschicht (4) eine Kombination aus während der Herstellung des Stapels durch die dielektrischen Schichten (2, 2a, 2b) leichter und schlechter diffundierbarem Sollbruchmaterial enthält, wobei das leichter diffundierbare Sollbruchmaterial der Sollbruchschicht (4) vor dem Sintern zu einem geringeren Anteil in der Elektrodenschicht (3) enthalten ist.

2. Piezoelektrisches Vielschichtbauelement nach Anspruch 1, bei dem einer jeden Elektrodenschicht (3) eine Sollbruchschicht (4) in Stapelrichtung benachbart ist.

3. Piezoelektrisches Vielschichtbauelement nach einem der vorhergehenden Ansprüche, bei dem auf einer Ebene des Stapels mehrere sich lateral gegenüberliegende Sollbruchschichten (4) angeordnet sind.

4. Piezoelektrisches Vielschichtbauelement nach einem der vorhergehenden Ansprüche, bei dem die Sollbruchschicht (4) porös ist.

5. Piezoelektrisches Vielschichtbauelement nach einem der vorhergehenden Ansprüche, bei dem die Sollbruchschicht (4) vor dem Sintern zwischen 85 und 99% und die Elektrodenschicht (3) zwischen 15 und 1% Silber enthält.

6. Piezoelektrisches Vielschichtbauelement nach Anspruch 5, bei dem die Sollbruchschicht (4) vor dem Sintern zwischen 15% und 1% und die Elektrodenschicht (3) zwischen 85 und 99% Palladium enthält.

7. Piezoelektrisches Vielschichtbauelement nach einem der vorhergehenden Ansprüche, bei dem in derselben Ebene des Vielschichtbauelements neben einer Elektrodenschicht (3) eine Sollbruchschicht (4) angeordnet ist und beide mittels eines Dielektrikums voneinander elektrisch isoliert sind.

8. Piezoelektrisches Vielschichtbauelement nach Anspruch 7, bei dem einander zugewandte Ränder der Elektrodenschicht (3) und der Sollbruchschicht (4) komplementäre Verläufe aufzeichnen.

9. Verfahren zur Herstellung eines piezoelektrisches Vielschichtbauelements, bei dem
- erste piezokeramische Folien (2) mit einem Sollbruchmaterial bedruckt werden, dessen Gefüge im Laufe der Herstellung des Vielschichtbauelements mechanisch instabil wird und dabei eine Sollbruchschicht (4) erzeugt wird, wobei
- die Sollbruchschicht (4) eine Kombination aus während der Herstellung des Stapels durch die dielektrischen Schichten (2, 2a, 2b) leichter und schlechter diffundierbarem Sollbruchmaterial enthält, wobei das leichter diffundierbare Sollbruchmaterial der Sollbruchschicht (4) vor dem Sintern zu einem geringeren Anteil in der Elektrodenschicht (3) enthalten ist und
- die ersten piezokeramischen Folien und zweite piezokeramischen Folien, welche Elektrodenschichten (3) aufweisen, derart zu einem Stapel bereitgestellt werden, dass die Fläche einer Sollbruchschicht in orthogonaler Projektion keine Überlappfläche mit einer benachbarten Elektrodenschicht aufweist, und
- der Stapel zu einem monolithischen Vielschichtbauelement gesintert wird.

10. Verfahren nach Anspruch 9, bei dem die Erzeugung der mechanischen Instabilität der Sollbruchschicht (4) während des Erwärmens des Vielschichtbauelements stattfindet.

11. Verfahren nach einem der Ansprüche 9 oder 10, bei dem das Sollbruchmaterial im Laufe des Herstellungsverfahrens eine poröse Sollbruchschicht (4) auf den ersten piezokeramischen Schichten hinterlässt.

12. Verfahren nach einem der Ansprüche 9 bis 11, bei dem eine Diffusion des Sollbruchmaterials von der Sollbruchschicht (4) in einen eine niedrigere Konzentration des Sollbruchmaterials aufweisenden Bereich des Vielschichtbauelements auftritt.

## Claims

1. A piezoelectric multilayer component, comprising a basic body (1) having a stack of dielectric layers (2, 2a, 2b), electrode layers (3) and at least one predetermined breaking layer (4), wherein
- the predetermined breaking layer is arranged at least for the most part in an inactive zone (5), and wherein
- the predetermined breaking layer cracks under specific tensile loads, and wherein
- the predetermined breaking layer (4) contains a combination of predetermined breaking material which is more readily diffusible and which is more poorly diffusible through the dielectric layers (2, 2a, 2b) during the production of the stack, wherein, before sintering, a lower proportion of the more readily diffusible predetermined breaking material of the predetermined breaking layer (4) is contained in the electrode layer (3).

2. Piezoelectric multilayer component according to Claim 1, wherein a predetermined breaking layer (4) is adjacent to each electrode layer (3) in the stacking direction.

3. Piezoelectric multilayer component according to any of the preceding claims, wherein a plurality of predetermined breaking layers (4) lying laterally opposite one another are arranged on a plane of the stack.

4. Piezoelectric multilayer component according to any of the preceding claims, wherein the predetermined breaking layer (4) is porous.

5. Piezoelectric multilayer component according to any of the preceding claims, wherein the predetermined breaking layer (4), before sintering, contains between 85 and 99% and the electrode layer (3) between 15 and 1% silver.

6. Piezoelectric multilayer component according to Claim 5, wherein the predetermined breaking layer (4), before sintering, contains between 15% and 1% and the electrode layer (3) between 85 and 99% palladium.

7. Piezoelectric multilayer component according to any of the preceding claims, wherein a predetermined breaking layer (4) is arranged alongside an electrode layer (3) in the same plane of the multilayer component and both are electrically insulated from one another by means of a dielectric.

8. Piezoelectric multilayer component according to Claim 7, wherein mutually facing edges of the electrode layer (3) and of the predetermined breaking layer (4) plot complementary courses.

9. Method for producing a piezoelectric multilayer component, wherein
- first piezoceramic sheets (2) are printed with a predetermined breaking material, the microstructure of which becomes mechanically unstable in the course of the production of the multilayer component and a predetermined breaking layer (4) is produced in the process, wherein
- the predetermined breaking layer (4) contains a combination of predetermined breaking material which is more readily diffusible and which is more poorly diffusible through the dielectric layers (2, 2a, 2b) during the production of the stack, wherein, before sintering, a lower proportion of the more readily diffusible predetermined breaking material of the predetermined breaking layer (4) is contained in the electrode layer (3), and
- the first piezoceramic sheets and second piezoceramic sheets having electrode layers (3) are provided so as to form a stack in such a way that the area of a predetermined breaking layer in orthogonal projection has no area of overlap with an adjacent electrode layer, and
- the stack is sintered to form a monolithic multilayer component.

10. Method according to Claim 9, wherein the production of the mechanical instability of the predetermined breaking layer (4) takes place during the heating of the multilayer component.

11. Method according to either of Claims 9 or 10, wherein the predetermined breaking material leaves a porous predetermined breaking layer (4) on the first piezoceramic layers in the course of the production method.

12. Method according to any of Claims 9 to 11, wherein a diffusion of the predetermined breaking material occurs from the predetermined breaking layer (4) into a multilayer component region having a lower concentration of the predetermined breaking material.

## Revendications

1. Composant multicouche piézoélectrique, comprenant un corps de base (1) comportant un empilement de couches diélectriques (2, 2a, 2b), des couches d'électrode (3) et au moins une couche de rupture théorique (4) ;
- la couche de rupture théorique étant disposée au moins en majeure partie dans une zone inactive (5) ; et
- la couche de rupture théorique se déchirant en cas d'application d'une sollicitation en traction définie ; et
- la couche de rupture théorique (4) contenant une combinaison de matériau de rupture théorique assez facilement et assez difficilement diffusable à travers les couches diélectriques (2, 2a, 2b) lors de la fabrication de l'empilement, le matériau de rupture théorique assez facilement diffusable de la couche de rupture théorique (4) étant présent en quantité assez réduite dans la couche d'électrode (3) avant le frittage.

2. Composant multicouche piézoélectrique selon la revendication 1, dans lequel une couche de rupture théorique (4) se place à proximité de chaque couche d'électrode (3) dans la direction de l'empilement.

3. Composant multicouche piézoélectrique selon l'une quelconque des revendications précédentes, dans lequel plusieurs couches de ruptures opposées en côté théorique (4) sont disposées sur un plan de l'empilement.

4. Composant multicouche piézoélectrique selon l'une quelconque des revendications précédentes, dans lequel la couche de rupture théorique (4) est poreuse.

5. Composant multicouche piézoélectrique selon l'une quelconque des revendications précédentes, dans lequel la couche de rupture théorique (4) contient entre 85 et 99 % d'argent et dans lequel la couche d'électrode (3) contient entre 15 et 1 % d'argent avant le frittage.

6. Composant multicouche piézoélectrique selon la revendication 5, dans lequel la couche de rupture théorique (4) contient entre 15 % et 1 % de palladium et dans lequel la couche d'électrode (3) contient entre 85 et 99 % de palladium avant le frittage.

7. Composant multicouche piézoélectrique selon l'une quelconque des revendications précédentes, dans lequel une couche de rupture théorique (4) est disposée dans le même plan que le composant multicouche à côté d'une couche d'électrode (3) et dans lequel les deux couches sont isolées l'une de l'autre au moyen d'un milieu diélectrique.

8. Composant multicouche piézoélectrique selon la revendication 7, dans lequel les bords orientés l'un vers l'autre de la couche d'électrode (3) et de la couche de rupture théorique (4) présentent un tracé complémentaire.

9. Procédé de fabrication d'un composant multicouche piézoélectrique, dans lequel :
- des premiers films piézocéramiques (2) sont imprimés au moyen d'un matériau de rupture théorique dont la structure est rendue mécaniquement instable au cours de la fabrication du composant multicouche et produit en l'occurrence une couche de rupture théorique (4) ;
- la couche de rupture théorique (4) contenant une combinaison de matériau de rupture théorique assez facilement et assez difficilement diffusable à travers les couches diélectriques (2, 2a, 2b) lors de la fabrication de l'empilement, le matériau de rupture théorique assez facilement diffusable de la couche de rupture théorique (4) étant présent en quantité assez réduite dans la couche d'électrode (3) avant le frittage ; et
- les premiers films piézocéramiques et les deuxièmes films piézocéramiques comportant des couches d'électrode (3) mises à disposition d'un empilement de telle sorte que la surface d'une couche de rupture théorique ne comporte aucune surface de chevauchement avec une couche d'électrode connexe en projection perpendiculaire ; et
- l'empilement est fritté pour former un composant multicouche monolithique.

10. Procédé selon la revendication 9, dans lequel la réalisation de l'instabilité mécanique de la couche de rupture théorique (4) se produit pendant le chauffage du composant multicouche.

11. Procédé selon l'une quelconque des revendications 9 ou 10, dans lequel le matériau de rupture théorique laisse derrière lui une couche de rupture théorique (4) poreuse sur les premières couches piézocéramiques au cours du procédé de fabrication.

12. Procédé selon l'une quelconque des revendications 9 à 11, dans lequel une diffusion du matériau de rupture théorique se produit de la couche de rupture théorique (4) dans une zone du composant multicouche présentant une concentration inférieure en matériau de rupture théorique.
